(19) **Europäisches Patentamt**
**European Patent Office**
**Office européen des brevets**

(11) **EP 4 515 264 B1**

(12) **FASCICULE DE BREVET EUROPEEN**

(45) Date de publication et mention de la délivrance du brevet:
**10.12.2025 Bulletin 2025/50**

(21) Numéro de dépôt: **23725283.8**

(22) Date de dépôt: **17.04.2023**

(51) Classification Internationale des Brevets (IPC):
**G01R 31/3842** *(2019.01)* **G01R 31/388** *(2019.01)*

(52) Classification Coopérative des Brevets (CPC):
**G01R 31/3842; G01R 31/388**

(86) Numéro de dépôt international:
**PCT/FR2023/050547**

(87) Numéro de publication internationale:
**WO 2023/209309 (02.11.2023 Gazette 2023/44)**

(54) **PROCÉDÉ ET SYSTÈME D'ESTIMATION DE L'ÉTAT DE CHARGE DISPONIBLE D'UNE BATTERIE EN FONCTION DE LA TENSION INSTANTANÉE**

**VERFAHREN UND SYSTEM ZUR SCHÄTZUNG DES VERFÜGBAREN LADEZUSTANDS EINER BATTERIE IN ABHÄNGIGKEIT DER MOMENTANSPANNUNG**

**METHOD AND SYSTEM FOR ESTIMATING THE AVAILABLE STATE OF CHARGE OF A BATTERY ACCORDING TO THE INSTANTANEOUS VOLTAGE**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **27.04.2022 FR 2203955**

(43) Date de publication de la demande:
**05.03.2025 Bulletin 2025/10**

(73) Titulaires:
- **Safran Electrical & Power**
  **31702 Blagnac Cedex (FR)**
- **UNIVERSITE DE TECHNOLOGIE DE COMPIEGNE**
  **60200 Compiegne (FR)**
- **Centre National de la Recherche Scientifique (CNRS)**
  **75016 Paris (FR)**

(72) Inventeurs:
- **VENDRAME, Fernanda**
  **77550 MOISSY CRAMAYEL (FR)**
- **SAYEGH, Marie**
  **77550 MOISSY CRAMAYEL (FR)**
- **FORGEZ, Christophe**
  **60201 COMPIEGNE (FR)**

(74) Mandataire: **Casalonga**
**Casalonga & Partners**
**Bayerstraße 71/73**
**80335 München (DE)**

(56) Documents cités:
**EP-A1- 2 848 952     US-A1- 2019 033 379**
**US-A1- 2022 065 934**

## Description

### *Domaine technique*

L'invention a pour domaine technique les batteries électriques, et plus particulièrement l'estimation de l'état de charge de telles batteries.

### *Techniques antérieures*

L'état de charge ou SOC (acronyme anglophone pour « State of Charge ») d'une batterie indique la quantité de charge présente dans la batterie. Il peut être exprimé en valeur absolue (Ah) ou relative par rapport à la charge maximale que peut avoir la batterie (%). L'état de charge SOC n'est pas une grandeur mesurable, donc il doit être estimé à partir des mesures disponibles (courant, tension, température).

La méthode utilisée le plus couramment pour calculer l'état de charge SOC est le comptage coulombmétrique, qui consiste à intégrer le courant dans le temps. Cela est applicable lorsque l'état de charge SOC initial est connu. L'état de charge SOC à un instant t est donc exprimé (en Ah) par :

$$SOC_{stored}(t) = SOC_{stored,0} + \frac{1}{3600} \int_0^t I(t)dt \qquad [\text{Eq. 1}]$$

Si on souhaite l'exprimer en pourcentage $SOC_{stored\_relative}$, il suffit de le diviser par l'état de charge maximal $SOC_{max}$ de la batterie.

$$SOC_{stored\_relative}(t) = 100 \frac{SOC_{stored}(t)}{SOC_{max}} \qquad [\text{Eq. 2}]$$

L'état de charge $SOC_{stored}$ estimé par comptage coulombmétrique donne une information sur la capacité stockée dans la batterie. Il est pourtant dangereux de se fier à cette information toute seule car une partie de cette capacité peut potentiellement être indisponible, surtout à basse température et/ou courant élevé. Ces variations de capacité disponible résultent des variations de l'impédance interne de la batterie. Lorsqu'on fait passer un courant en décharge dans la batterie, la tension aux bornes de la batterie diminue de façon proportionnelle à l'impédance de la batterie et au courant entre ses bornes.

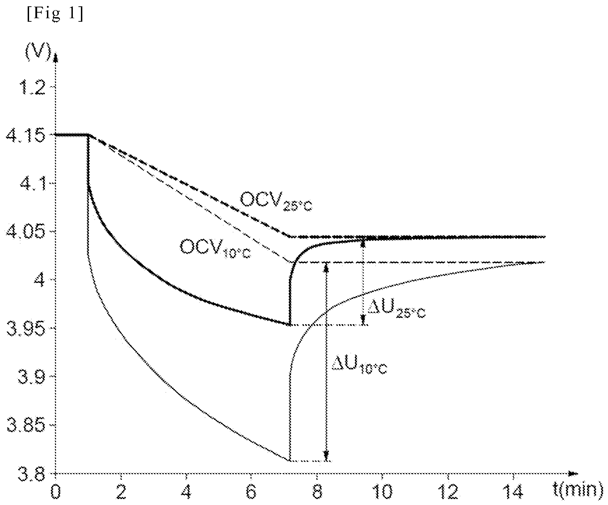

La Figure 1 montre l'évolution de la tension aux bornes de la batterie au cours du temps lors d'une décharge à courant 1C à deux températures différentes, 10°C et 25°C. Les courbes en trait fort sont associées à la température 25°C tandis que les courbes en trait fin sont associées à la température 10°C. L'impédance de la batterie augmente lorsque la température diminue, donc la chute de tension entrainée est plus importante. De façon analogue, si l'impédance est la même, la chute de tension sera plus élevée pour un courant plus élevé. Il est important de noter que la décharge de la batterie s'arrête lorsque la tension la plus faible autorisée est atteinte. Or, pour un même état de charge stocké $SOC_{stored}$, cette tension est atteinte plus rapidement si le courant est élevé ou si la température est faible. Dans ces circonstances, l'état de charge disponible $SOC_{available}$ est plus faible.

Dans ce contexte, il devient crucial de faire la différence entre l'état de charge stocké $SOC_{stored}$ et l'état de charge disponible $SOC_{available}$. L'état de charge disponible $SOC_{available}$ est théoriquement une fonction de l'état de charge stocké $SOC_{stored}$, de la température T et du courant I :

$$SOC_{available} = f(SOC_{stored}, T, I) \qquad [\text{Eq. 3}]$$

Un problème technique à résoudre consiste à déterminer la fonction entre l'état de charge disponible $SOC_{available}$, le courant et la température ou à trouver un autre moyen de prendre en compte les effets du courant et de la température sur l'état de charge disponible $SOC_{available}$.

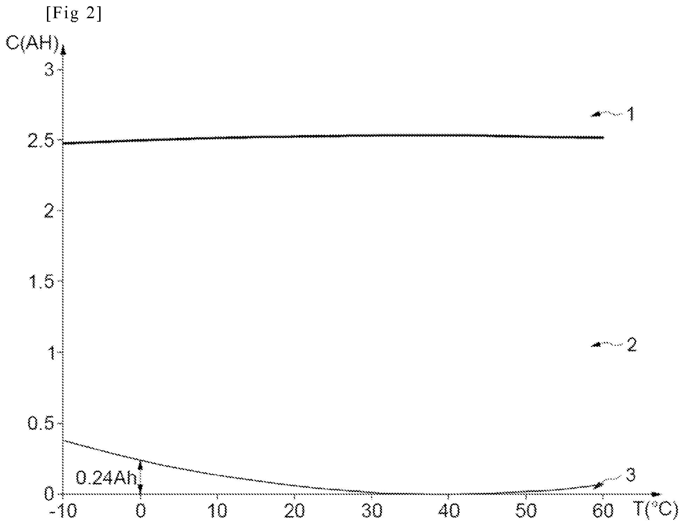

En ce qui concerne la température, il est possible de faire une série d'essais de charge et décharge de la batterie à un courant suffisamment faible (de sorte à ne pas chauffer la batterie pendant l'essai) pour obtenir les valeurs limites de charge stockée dans la batterie. La Figure 2 illustre la capacité de la batterie disponible en fonction de la température, et vis-à-vis des opérations de charge ou de décharge. La zone 1 correspond à la capacité indisponible en charge en fonction de la température. La zone 3 correspond à la capacité indisponible en décharge en fonction de la température. La zone 2 correspond à la capacité disponible en charge et en décharge en fonction de la température. Par exemple, en fin de décharge à une température de 0°C, environ 0.24 Ah restent stockés dans la batterie et ne sont pas disponibles à la décharge. On en déduit ainsi que l'état de charge disponible $SOC_{available}$ à 0°C est inférieur à l'état de charge stocké

$SOC_{stored}$ de 0.24 Ah.

Cependant, cette démarche ne peut pas être adoptée pour étudier la dépendance de la capacité disponible au courant, car les forts courants font chauffer la batterie et la valeur de capacité mesurée ne peut donc pas être associée à un point de fonctionnement spécifique.

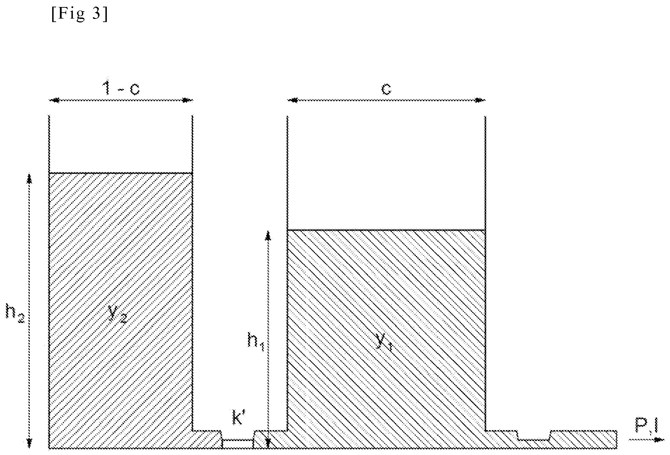

Une approche qui permet de modéliser la variation de capacité disponible avec le courant est le modèle cinétique, illustré sur la Figure 3. Le réservoir de droite contient y1, qui correspond à la charge/énergie disponible. Sa largeur est c, inférieur à 1. Le niveau de ce réservoir est hl, qui représente l'état de charge SOC/l'état d'énergie SOE. Le réservoir de gauche contient y2, qui est la charge/énergie contrainte. Sa largeur est 1-c et son niveau est h2. Lorsqu'une sollicitation est appliquée (un courant I si on parle d'un réservoir de charge ou une puissance P si on parle d'un réservoir d'énergie), le niveau du réservoir de droite diminue. En même temps, la charge/énergie peut passer du réservoir de gauche à celui de droite en passant par une vanne k', qui fait que le débit en entrée du réservoir de droite est toujours plus faible que celui en sortie. Plus la sollicitation appliquée n'est importante, plus rapidement la différence de niveau entre les deux réservoirs va augmenter. La charge/énergie indisponible est donc (1-c)*(h1-h2). Cependant, dès que la sollicitation s'arrête, le niveau du réservoir de droite commence à augmenter, ce qu'on appelle la récupération de la charge/énergie. Ce comportement est une analogie à la diffusion qui se produit dans la batterie. En effet, lorsqu'une sollicitation élevée est appliquée, la surtension (différence entre la tension cellule et sa tension en circuit ouvert OCV (acronyme anglophone pour « Open Circuit Voltage »)) peut augmenter significativement et si la tension de la batterie est déjà proche de sa limite inférieure, la décharge peut être interrompue. Cependant, cette décharge pourrait très bien être reprise à un courant/une puissance plus faible et on peut même imaginer qu'un courant/une puissance infinitésimal(e) pourrait décharger complètement la batterie.

Les équations qui régissent ce modèle sont les suivantes :

$$\begin{cases} \frac{dy_1}{dt} = -I - k'(h_1 - h_2) \\ \frac{dy_2}{dt} = k'(h_1 - h_2) \end{cases} \qquad [Eq. 4]$$

Pour paramétrer ce modèle, il est nécessaire de générer des profils à différents courants et températures à partir du modèle électrique de la batterie et d'utiliser un algorithme d'optimisation pour trouver, à chaque température, un couple (k', c) qui permet d'obtenir y1 = 0 à la fin de la décharge à chaque courant. Ensuite, ces deux paramètres permettent d'obtenir Ymax, qui est la capacité/énergie maximale qui peut être stockée dans la batterie à la température en question.

Malheureusement, ce modèle présente un niveau de complexité élevé et son paramétrage dépend de la qualité des profils obtenus à partir du modèle électrique. Nous avons donc des erreurs du modèle électrique et des erreurs de paramétrage du modèle cinétique qui s'accumulent.

En résumé, la charge disponible dans une batterie est différente de la charge stockée et dépend de la température et du courant électrique. Il est possible d'estimer la charge disponible dans une batterie à différentes températures et à courant constant faible.

Cependant, cela ne peut pas être fait pour des courants élevés car ils font augmenter significativement la température de la batterie, ce qui empêche d'avoir une mesure de la charge disponible à une température donnée pour différents courants. Or, la tension de la batterie est directement influencée par la température et le courant. Par ailleurs, la tension est le principal critère d'arrêt d'une décharge. Cette information peut donc être utilisée pour trouver l'état de charge SOC disponible à partir du SOC stocké.

Il existe un besoin pour une méthode de détermination de l'état de charge disponible d'une batterie permettant de prendre en compte l'effet de la température et du courant, même pour des courants élevés.

De l'état de la technique antérieure, on connait le document US2022/065934 divulguant un système de batterie comprenant une batterie et un dispositif d'estimation de l'état de la batterie en fonction d'un modèle.

L'état de la technique ne répond pas au besoin identifié plus haut car les modèles disponibles sont soit incomplets, soit difficiles à paramétrer.

## Exposé de l'invention

L'invention a pour objet un procédé d'estimation de l'état de charge d'une batterie selon la revendication indépendante 1 comprenant les étapes suivantes :

- détermination de l'état de charge stocké,
- détermination de la tension instantanée en circuit ouvert de la batterie en fonction d'une cartographie prédéterminée, de l'état de charge stocké et de la température,
- mesure de la tension instantanée aux bornes de la batterie,

- détermination de l'état de charge disponible en fonction de l'état de charge stocké, de la tension instantanée, de la tension instantanée en circuit ouvert et d'une tension minimale admissible,
- la tension minimale admissible étant une donnée prédéterminée par conception,

le procédé étant caractérisé en ce qu'il comprend l'étape suivante:

- pour déterminer l'état de charge disponible, on réalise le produit de l'état de charge stocké par le rapport entre la différence entre la tension instantanée et la tension minimale admissible et la différence entre la tension en circuit ouvert et la tension minimale admissible.

La détermination de l'état de charge stocké peut être réalisée en réalisant les étapes suivantes : la détermination de l'état de charge stocké est réalisée en réalisant les étapes suivantes :

- mesure de la tension en circuit ouvert de la batterie au repos
- détermination de l'état de charge stocké initial en fonction d'une table liant l'état de charge stocké initial à la tension en circuit ouvert au repos de la batterie et à la température,
- utilisation de la batterie en charge et/ou en décharge,
- mesure périodique du courant instantané,
- intégration du courant instantané mesuré depuis le début de l'utilisation après chaque mesure du courant instantané, et
- détermination de l'état de charge stocké comme la somme du résultat de l'intégration et de la valeur de l'état de charge stocké initial.

La détermination de l'état de charge stocké peut être également réalisée par un observateur de Kalman avec un vecteur d'état défini par l'état de charge stocké et une tension de diffusion, le vecteur de sortie étant la tension instantanée de la batterie

On peut déterminer l'état de charge disponible futur d'une batterie comme étant égal à l'état de charge disponible déterminé lorsque la tension instantanée de la batterie est une tension future.

L'invention a également pour objet un système d'estimation de l'état de charge d'une batterie selon la revendication indépendante 5 comprenant des moyens de traitement de données, au moins une mémoire, au moins un moyen de mesure de la tension aux bornes de la batterie, et au moins un moyen de mesure du courant circulant entre les bornes de ladite batterie, les moyens de traitement de données étant configurés pour réaliser les étapes de procédé de détermination telles que décrites ci-dessus.

### Brève description des dessins

D'autres buts, caractéristiques et avantages de l'invention apparaîtront à la lecture de la description suivante, donnée uniquement à titre d'exemple non limitatif et faite en référence aux dessins annexés sur lesquels :

- la figure 1 illustre un exemple de décharge d'une batterie à courant 1C à deux températures différentes,
- la figure 2 illustre la capacité stockée en fin de charge et en fin de décharge en fonction de la température,
- la figure 3 illustre le modèle cinétique de décharge d'une batterie,
- la figure 4 illustre la comparaison de l'évolution de l'état de charge en fonction du temps pour une décharge continue à 3C et 0°C selon plusieurs méthodes de détermination.

### Description détaillée

Comme on l'a vu en introduction, la tension de la batterie est directement influencée par le courant et la température. Plus le courant est élevé, plus la variation de tension est importante. La contribution de la température est inverse de sorte que plus la température est faible, plus les résistances électriques sont élevées et la variation de tension est importante. On peut donc se servir de la tension pour calculer l'état de charge disponible $SOC_{available}$. Dans ce cas, dès que la tension atteint une valeur limite entraînant l'arrêt de la décharge, l'état de charge disponible $SOC_{available}$ doit être nul. Cela est satisfait par l'équation [Eq. 5] ci-dessous.

La méthode d'estimation d'état de charge selon l'invention est basée sur ce constat.

L'état de charge stocké initial $SOC_{stored,0}$ est déterminé en fonction de la tension de circuit ouvert OCV (acronyme pour « Open Circuit Voltage ») et de la température, lorsque la batterie estau repos et relaxée. Par batterie au repos et relaxée, on entend une batterie dont l'utilisation est interrompue depuis une durée suffisamment longue pour que la tension de la batterie atteigne la tension de circuit ouvert OCV et que la température de la batterie atteigne la température ambiante

Lors de la décharge, le courant est mesuré périodiquement et ensuite intégré après chaque mesure de courant depuis le début de la décharge afin de déterminer l'état de charge stocké $SOC_{stored}$, par comptage coulombmétrique par application de l'équation [Eq. 1].

Alternativement, l'état de charge stocké $SOC_{stored}$ est déterminé par une estimation par observateur de Kalman.

L'observateur de Kalman estime à chaque instant la valeur des variables d'état en fonction de leur valeur à l'instant précédent et des entrées du système. Ensuite, la sortie du système est calculée en fonction de ces variables d'état et comparée avec une valeur mesurée. Selon l'écart observé et les réglages du filtre, un facteur de correction plus ou moins important est appliqué aux variables d'état. Il s'agit donc de régler ces variables qui ne sont pas mesurables de sorte que la sortie, qui dépend de ces variables, soit cohérente avec une variable qui peut être mesurée.

$$\text{Le vecteur d'état x est } x = \begin{cases} SOC_{stored} \\ U_{diff} \end{cases}$$

Avec SOC : l'état de charge de la batterie, et Udiff : tension interne qui traduit les phénomènes dynamiques de diffusion, qui fait partie intégrante de la tension batterie tel que :

$$Udiff + OCV + R_S * I = U(t)$$

Avec Rs*I tension interne liée aux phénomènes statiques et Rs la résistance associée.

Le vecteur de commande u est $u = \{I\}$

Avec I : le courant de charge ou décharge
L'équation d'état est alors la suivante :

$$x_{k+1} = A.x_k + B.u_k$$

Avec A et B : deux matrices de coefficients
Le vecteur de sortie est $y = \{U(t)\}$
Avec U(t) : la tension globale de la batterie à l'instant t
La sortie du système est alors la suivante :

$$y_{k+1} = C.x_k + D.u_k$$

Avec C et D : deux matrices de coefficients

Le filtre de Kalman est initialisé par la méthode des matrices de covariance, avec une matrice de covariance R du bruit de processus, une matrice de covariance Q du bruit d'observation et une matrice de covariance P d'erreur d'état. Les matrices R et Q peuvent rester constantes tout le long de l'observation, tandis que la matrice P est recalculée à chaque instant.

A partir de la détermination de l'état de charge stocké $SOC_{stored}$ et indifféremment de la méthode d'estimation de l'état de charge stocké $SOC_{stored}$ employée, on calcule l'état de charge disponible $SOC_{available}$ par application de l'équation suivante :

$$SOC_{available}(t) = SOC_{stored}(t) \cdot \frac{U(t)-U_{min}}{OCV(t)-U_{min}} \qquad [\text{Eq. 5}]$$

Avec :

$SOC_{stored}$ : l'état de charge SOC stocké.
U(t) : la tension globale de la batterie à l'instant t et
$U_{min}$ : la tension minimale admissible, qui définit la fin de la décharge.
OCV(t) : la tension de circuit ouvert à l'instant t

On notera que la tension de circuit ouvert à l'instant t OCV(t) varie à chaque instant. On rappelle que la tension de circuit ouvert OCV est déterminée comme la tension de la batterie lorsqu'elle n'est connectée à aucune charge ou source de puissance. On comprend alors que la tension de circuit ouvert OCV ne peut être déterminée lors de l'utilisation de la batterie. On utilise alors une cartographie de la tension de circuit ouvert OCV(t) en fonction de l'état de charge stocké $SOC_{stored}(t)$ et de la température de la batterie T. La cartographie est déterminée par essais en mesurant la tension OCV pour différents états de charge stocké $SOC_{stored}$ et pour différentes températures T. Un exemple de telle cartographie est illustré en traits discontinus sur la figure Fig. 1.

La tension minimale $U_{min}$ est une donnée constructeur liée à la batterie.

Avec l'équation [Eq. 5], il est possible de prendre en compte à la fois les effets du courant et de la température. Dans ce cas, on admet que l'état de charge disponible $SOC_{available}$ est égal à l'état de charge stocké $SOC_{stored}$ lorsque la batterie est au repos (U=OCV), quelle que soit la température. Dès que la batterie sera sollicitée, la surtension produite U(t)-OCV(t) (et donc la réduction du SOC disponible) est d'autant plus importante que la résistance est élevée et donc que la température est faible. La surtension est aussi d'autant plus importante que le courant est élevé.

Cette méthode d'estimation fait que l'état de charge disponible $SOC_{available}$ diminue et augmente suivant la même allure de la tension. Cette méthode permet donc de prévoir les coupures de décharge très efficacement, car l'état de charge disponible $SOC_{available}$ est toujours nul lorsque la tension atteint sa valeur limite et ce, même si l'état de charge stocké $SOC_{stored}$ a été mal initialisé.

Le procédé d'estimation de l'état de charge selon l'invention comprend ainsi les étapes suivantes :
Au cours d'une première étape, on détermine l'état de charge stocké $SOC_{stored}(t)$ et on détermine la tension instantanée en circuit ouvert OCV(t) de la batterie en fonction de l'état de charge stocké $SOC_{stored}(t)$ et de la température de la batterie T.

Au cours d'une deuxième étape, on mesure la tension instantanée U(t) aux bornes de la batterie.

Au cours d'une troisième étape, on détermine l'état de charge disponible $SOC_{available}(t)$ en fonction de l'état de charge stocké $SOC_{stored}(t)$, de la tension instantanée U(t), de la tension instantanée en circuit ouvert OCV(t) et de la tension minimale admissible $U_{min}$ en appliquant l'équation [Eq. 5].

La tension minimale admissible $U_{min}$ est une donnée constructeur prédéterminée.

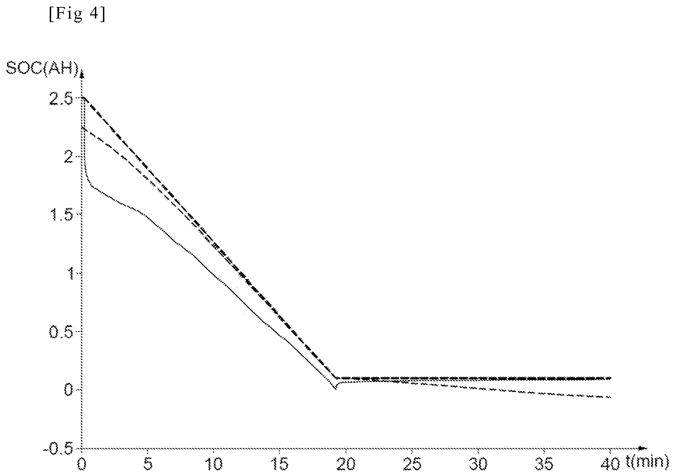

La Figure 4 montre des résultats de la méthode d'estimation de l'état de charge selon l'invention pour une décharge continue à 3C et 0°C. La courbe en trait fort et tirets correspond à l'état de charge stocké $SOC_{stored}$, la courbe en trait léger et tirets correspond à l'état de charge disponible $SOC_{available}$ obtenu avec une méthode qui prend en compte la température mais pas le courant (cf. Figure 2) et la courbe en trait continu correspond à l'état de charge disponible $SOC_{available}$ obtenu par la méthode selon l'invention. Cette méthode, au contraire des autres, indique bien que l'état de charge SOC à la fin de la décharge est de 0 Ah. Par ailleurs, cette méthode permet d'estimer dès le début du profil que l'état de charge SOC disponible diminue drastiquement en raison du courant élevé.

Dans un autre mode de réalisation, au lieu d'utiliser la tension mesurée U(t) pour déterminer l'état de charge disponible SOC, il est possible d'utiliser une tension simulée correspondant à une tension future. L'état de charge disponible SOC est alors égal à l'état de charge disponible SOC audit instant futur pour un profil de courant ou de puissance donné correspondant à la tension future.

Cette méthode, présentée pour estimer l'état de charge SOC disponible, peut également être appliquée au SOE (State of Energy). On privilégie l'utilisation de l'état de charge SOC afin de déterminer la charge de la batterie lorsqu'un courant est imposé. L'état d'énergie, qui est lié à la puissance disponible et indirectement des pertes du système, notamment thermiques, est privilégié lorsqu'une puissance est imposée à la batterie.

L'estimateur d'état de charge permet donc d'estimer avec justesse l'état de charge SOC disponible en tenant compte des effets du courant et de la température.

Le procédé d'estimation de l'état de charge disponible d'une batterie a été décrit ci-dessus en rapport avec la décharge d'une batterie. Néanmoins, la personne du métier comprendra aisément que le procédé décrit peut s'appliquer indistinctement à une batterie en charge, en décharge ou soumise à une combinaison de charges et de décharges.

**Revendications**

**1.** Procédé d'estimation de l'état de charge d'une batterie comprenant les étapes suivantes :

- détermination de l'état de charge stocké ($SOC_{stored}$),
- détermination de la tension instantanée en circuit ouvert (OCV) de la batterie en fonction d'une cartographie prédéterminée, de l'état de charge stocké ($SOC_{stored}$), et de la température,
- mesure de la tension instantanée (U(t)) aux bornes de la batterie,
- détermination de l'état de charge disponible ($SOC_{available}$) en fonction de l'état de charge stocké ($SOC_{stored}$), de la tension instantanée (U(t)), de la tension instantanée en circuit ouvert (OCV) et d'une tension minimale admissible ($U_{min}$),
- la tension minimale admissible ($U_{min}$) étant une donnée

prédéterminée par conception, le procédé étant **caractérisé en ce qu'**il comprend l'étape suivante:

- pour déterminer l'état de charge disponible ($SOC_{available}$), on réalise le produit de l'état de charge stocké ($SOC_{stored}$) par le rapport entre la différence entre la tension instantanée (U(t)) et la tension minimale admissible ($U_{min}$) et la différence entre la tension en circuit ouvert (OCV) et la tension minimale admissible (Umin).

2. Procédé d'estimation selon la revendication 1, dans lequel la détermination de l'état de charge stocké est réalisée en réalisant les étapes suivantes :

- mesure de la tension en circuit ouvert (OCV) de la batterie au repos
- détermination de l'état de charge stocké initial ($SOC_{stored,0}$) en fonction d'une table liant l'état de charge stocké initial ($SOC_{stored,0}$) à la tension en circuit ouvert (OCV) au repos de la batterie et à la température,
- utilisation de la batterie en charge et/ou en décharge,
- mesure périodique du courant instantané,
- intégration du courant instantané mesuré depuis le début de l'utilisation après chaque mesure du courant instantané, et
- détermination de l'état de charge stocké ($SOC_{stored}$) comme la somme du résultat de l'intégration et de la valeur de l'état de charge stocké initial ($SOC_{stored,0}$).

3. Procédé d'estimation selon la revendication 1, dans lequel la détermination de l'état de charge stocké ($SOC_{stored}$) est réalisée par un observateur de Kalman avec un vecteur d'état défini par l'état de charge stocké ($SOC_{stored}$) et une tension de diffusion et un vecteur de sortie défini comme la tension instantanée (U(t)) de la batterie.

4. Procédé d'estimation selon l'une quelconque des revendications 1 à 3, dans lequel on détermine l'état de charge disponible futur d'une batterie comme étant égal à l'état de charge disponible ($SOC_{available}$) déterminé lorsque la tension instantanée (U(t)) de la batterie est une tension future.

5. Système d'estimation de l'état de charge d'une batterie comprenant des moyens de traitement de données, au moins une mémoire, au moins un moyen de mesure de la tension aux bornes de la batterie, et au moins un moyen de mesure du courant circulant entre les bornes de ladite batterie, les moyens de traitement de données étant configurés pour réaliser les étapes de procédé de détermination telles que revendiquées dans les revendications 1 à 4.

**Patentansprüche**

1. Verfahren zum Schätzen des Ladezustands einer Batterie, umfassend die folgenden Schritte:

- Bestimmen des gespeicherten Ladezustands ($SOC_{stored}$),
- Bestimmen der momentanen Leerlaufspannung (OCV) der Batterie in Abhängigkeit von einem vorbestimmten Kennfeld, dem gespeicherten Ladezustand ($SOC_{stored}$) und der Temperatur,
- Messen der Momentanspannung (U(t)) an den Klemmen der Batterie,
- Bestimmen des verfügbaren Ladezustands ($SOC_{available}$) in Abhängigkeit von dem gespeicherten Ladezustand ($SOC_{stored}$), der Momentanspannung (U(t)), der momentanen Leerlaufspannung (OCV) und einer minimal zulässigen Spannung ($U_{min}$),
- wobei die minimal zulässige Spannung ($U_{min}$) eine durch die Konstruktion vorbestimmte Angabe ist,

wobei das Verfahren **dadurch gekennzeichnet ist, dass** es den folgenden Schritt umfasst:

- zum Bestimmen des verfügbaren Ladezustands ($SOC_{available}$), Ermitteln des Produkts aus dem gespeicherten Ladezustand ($SOC_{stored}$) durch das Verhältnis zwischen der Differenz zwischen der momentanen Spannung (U(t)) und der minimal zulässigen Spannung ($U_{min}$) und der Differenz zwischen der Leerlaufspannung (OCV) und der minimal zulässigen Spannung (Umin).

2. Schätzverfahren nach Anspruch 1, wobei das Bestimmen des gespeicherten Ladezustands durch Durchführen der folgenden Schritte durchgeführt wird:

- Messen der Leerlaufspannung (OCV) der Batterie im Ruhezustand
- Bestimmen des ursprünglich gespeicherten Ladezustands ($SOC_{stored,0}$) in Abhängigkeit von einer Tabelle, die den ursprünglich gespeicherten Ladezustand ($SOC_{stored,0}$) mit der Leerlaufspannung (OCV) im Ruhezustand der Batterie und der Temperatur verknüpft,
- Verwenden der Batterie bei dem Laden und/oder Entladen,
- periodisches Messen des Momentanstroms,
- Integrieren des gemessenen Momentanstroms seit Beginn der Verwendung nach jeder Messung des Momentanstroms, und
- Bestimmen des gespeicherten Ladezustands ($SOC_{stored}$) als Summe aus dem Ergebnis der Integration und dem Wert des ursprünglich gespeicherten Ladezustands ($SOC_{stored,0}$).

3. Schätzverfahren nach Anspruch 1, wobei das Bestimmen des gespeicherten Ladezustands ($SOC_{stored}$) durch einen Kalman-Beobachter mit einem durch den gespeicherten Ladezustand ($SOC_{stored}$) und eine Diffusionsspannung definierten Zustandsvektor und einem als Momentanspannung (U(t)) der Batterie definierten Ausgangsvektor durchgeführt wird.

4. Schätzverfahren nach einem der Ansprüche 1 bis 3, wobei der zukünftig verfügbare Ladezustand einer Batterie als gleich dem verfügbaren Ladezustand ($SOC_{available}$) bestimmt wird, wenn die Momentanspannung (U(t)) der Batterie eine zukünftige Spannung ist.

5. System zum Schätzen des Ladezustands einer Batterie, umfassend Datenverarbeitungsmittel, mindestens einen Speicher, mindestens ein Mittel zur Messung der Spannung an den Klemmen der Batterie und mindestens ein Mittel zur Messung des Stroms, der zwischen den Klemmen der Batterie fließt, wobei die Datenverarbeitungsmittel so eingerichtet sind, dass sie die Schritte des Bestimmungsverfahrens gemäß den Ansprüchen 1 bis 4 durchführen.

**Claims**

1. Method for estimating the state of charge of a battery comprising the following steps:

   - determining the stored charge state ($SOC_{stored}$).
   - determining the instantaneous open-circuit voltage (OCV) of the battery according to a predetermined mapping, the stored charge state ($SOC_{stored}$), and the temperature,
   - measurement of the instantaneous voltage (U(t)) at the battery terminals,
   - determining the available state of charge ($SOC_{available}$) according to the stored state of charge ($SOC_{stored}$), the instantaneous voltage (U(t)), the instantaneous open-circuit voltage (OCV), and an allowable minimum voltage ($U_{min}$),
   - the allowable minimum voltage ($U_{min}$) is a predetermined design parameter,

   the method being **characterized in that** it comprises the following step:

   - to determine the available state of charge ($SOC_{available}$), the product of the stored state of charge ($SOC_{stored}$) is obtained by the ratio between the difference between the instantaneous voltage (U(t)) and the allowable minimum voltage ($U_{min}$) and the difference between the open-circuit voltage (OCV) and the allowable minimum voltage (Umin).

2. Estimation method according to claim 1, wherein the determination of the stored state of charge is made by performing the following steps:

   - measuring the open-circuit voltage (OCV) of the battery at rest
   - determining the initial stored state of charge ($SOC_{stored,0}$) according to a table relating the initial stored state of charge ($SOC_{stored,0}$) to the open-circuit voltage (OCV) of the battery at rest and the temperature,
   - using the battery when charging and/or discharging,
   - periodically measuring the instantaneous current,
   - integrating the instantaneous current measured from the start of use after each instantaneous-current measurement, and
   - determining the stored state of charge ($SOC_{stored}$) as the sum of the result of the integration and the value of the initial stored state of charge ($SOC_{stored,0}$).

3. Estimation method according to claim 1, wherein the determination of the stored state of charge ($SOC_{stored}$) is performed by a Kalman observer with a state vector defined by the stored state of charge ($SOC_{stored}$) and a diffusion voltage and an output vector defined as the instantaneous voltage ($U(t)$) of the battery.

4. Estimation method according to any one of claims 1 to 3, wherein the future available state of charge of a battery is determined as being equal to the available state of charge ($SOC_{available}$) determined when the instantaneous voltage ($U(t)$) of the battery is a future voltage.

5. System for estimating the state of charge of a battery comprising data processing means, at least one memory, at least one means for measuring the voltage at the terminals of the battery, and at least one means for measuring the current circulating between the terminals of said battery, the data processing means being configured to perform the determination method steps as claimed in claims 1 to 4.

[Fig 1]

[Fig 2]

[Fig 3]

[Fig 4]

**EP 4 515 264 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2022065934 A